# EUROPÄISCHE PATENTANMELDUNG

(11) **EP 4 198 888 A1**
(43) Veröffentlichungstag der Anmeldung: **21.06.2023**
(21) Anmeldenummer: 22212460.4
(22) Anmeldetag: 09.12.2022
(51) Int. Cl.: G06T 7/00, G06T 7/11, G06T 7/194, G06T 7/62

(54) **VORRICHTUNG UND VERFAHREN ZUM INSPIZIEREN VON BEHÄLTNISSEN**

(30) Priorität: 15.12.2021 DE 102021133276
(71) Anmelder: Krones AG, 93073 Neutraubling (DE)
(72) Erfinder: Gut, Thorsten, 93073 Neutraubling (DE); Bock, Thomas, 93073 Neutraubling (DE)
(74) Vertreter: Bittner, Bernhard

(57) **Zusammenfassung**

Verfahren zum Inspizieren von Behältnissen, wobei die Behältnisse mittels einer Transporteinrichtung entlang eines vorgegebenen Transportpfads transportiert werden und mittels einer Inspektionseinrichtung inspiziert werden, wobei die Inspektionseinrichtung mittels einer Bildaufnahmeeinrichtung wenigstens ein ortsaufgelöstes Bild eines zu inspizierenden Behältnisses aufnimmt und eine Bildauswerteeinrichtung dieses Bild auswertet. Erfindungsgemäß werden zur Auswertung dieses Bildes Daten eines Modells dieses Behältnisses verwendet.

## Beschreibung

Die vorliegende Erfindung bezieht sich auf eine Vorrichtung und ein Verfahren zum Inspizieren von Behältnissen, wobei die Behältnisse mittels einer Transporteinrichtung entlang eines vorgegebenen Transportpfads transportiert werden und mittels einer Inspektionseinrichtung inspiziert werden. Vorrichtungen und Verfahren zum Inspizieren von Behältnissen sind aus dem Stand der Technik seit langem bekannt. Üblicherweise nimmt die Inspektionseinrichtung wenigstens ein ortsaufgelöstes Bild eines zu inspizierenden Behältnisses auf und eine Bildauswerteeinrichtung wertet dieses Bild aus.

Bei verschiedenen Kontrollsystemen ist es nötig, die Flaschenkonturen in 2D oder 3D in der Software zu erstellen. Während dies bei 2D-Konturen noch einigermaßen "einfach" ist (Kontur der Flasche im Durchlicht), wird das bei 3D-Daten, die beispielsweise bei der Abwicklung der Flaschenoberfläche für eine 360°-Etikettenkontrolle erforderlich ist, sehr rechenintensiv.

Die aktuellen Systeme scannen entweder eine reale Flasche oder müssen die Kontur aus einer Bildaufnahme auswerten (mittels Helligkeitsunterschieden) oder müssen mittels Linien händisch "nachgezeichnet" werden. Die Basis ist stets eine reale Flasche. Dadurch können weitere Ungenauigkeiten in die gewünschte "Referenzkontur" einfließen.

Aus der WO 2019/185184 A1 ist eine Vorrichtung zur optischen Positionserkennung von transportierten Behältnissen bekannt. Hierzu ist eine Bildaufnahmeeinrichtung zur Aufnahme ortsaufgelöster Bilder und ein Hintergrundelement mit einem vorgegebenen Muster vorgesehen.

Der vorliegenden Erfindung liegt die Aufgabe zugrunde, die aus dem Stand der Technik bekannten Nachteile zu überwinden und eine kunden- und bedienerfreundliche Vorrichtung und ein Verfahren zum Inspizieren von Behältnissen bereitzustellen, welche die Ungenauigkeiten durch Verwendung einer realen Referenzflasche bei Flaschenkontrollsystemen möglichst verringern.

Die Aufgabe wird erfindungsgemäß durch die Gegenstände der unabhängigen Ansprüche gelöst. Vorteilhafte Ausführungsformen und Weiterbildungen der Erfindung sind Gegenstand der Unteransprüche.

Bei einem erfindungsgemäßen Verfahren zum Inspizieren von Behältnissen, wobei die Behältnisse mittels einer Transporteinrichtung entlang eines vorgegebenen Transportpfads transportiert werden und mittels einer Inspektionseinrichtung inspiziert werden, nimmt die Inspektionseinrichtung mittels einer Bildaufnahmeeinrichtung wenigstens ein ortsaufgelöstes Bild eines zu inspizierenden Behältnisses auf und eine Bildauswerteeinrichtung wertet dieses Bild aus. Die Transporteinrichtung kann dabei ein Transportband oder eine Transportkette sein.

Erfindungsgemäß werden zur Auswertung dieses Bildes Daten eines Modells dieses Behältnisses verwendet.

Mit anderen Worten wird zur Auswertung des aufgenommenen Bildes nicht ein reales Bild eines Behältnisses als Referenz verwendet, sondern es werden Daten verwendet, die von dem Modell des Behältnisses vorliegen. Auf diese Weise werden Ungenauigkeiten beim Einlesen der Referenzkontur eliminiert.

Unter Behältnissen sind Flaschen insbesondere aus Glas, Kunststoff, Pulpe, Metall oder Kunststoffvorformlinge zu verstehen.

Bevorzugt wird das Bild und bevorzugt werden die Bilder während des Transports aufgenommen. Bevorzugt erfolgt die Bildaufnahme, während das Behältnis entlang des Transportpfads bewegt wird. Bevorzugt befindet sich das Behältnis nicht zumindest teilweise und bevorzugt während der gesamten Aufnahmedauer des Bildes unbewegt in einer Aufnahmeposition.

Bevorzugt werden mehrere Bilder aufgenommen und zur Auswertung dieser Bilder werden bevorzugt Daten des Modells dieses Behältnisses verwendet. Bevorzugt wird das Behältnis zur Bildaufnahme belichtet, wobei bevorzugt hierfür wenigstens eine und bevorzugt mehrere Beleuchtungseinrichtungen vorgesehen sein können.

Unter einem Modell des Behältnisses ist insbesondere ein virtuelles Modell des Behältnisses zu verstehen, welches bevorzugt nicht (auch nicht teilweise) aus einem realen Behältnis erzeugt wurde. Dies bietet den Vorteil, dass dadurch nicht erst ein reales Behältnis etwa durch eine Kamera erfasst werden muss, um ein Referenzmodell zu erzeugen. Bevorzugt handelt es sich bei dem Modell um ein Modell der Außenwandung wenigstens eines Bereichs des Behältnisses und besonders bevorzugt um das gesamte Behältnis.

Dies bietet den Vorteil einer deutlich einfacheren Einrichtung der Vorrichtung zum Inspizieren der Behältnisse, welches auch schon vorher im Haus der Herstellung der Inspektionsvorrichtung vorgenommen werden kann, statt erst beim Kunden bzw. beim Betreiber mit realen Behältern.

Bevorzugt werden zur Auswertung eines aufgenommenen Bildes keine Daten eines Referenzmodells verwendet, welche zu einem realen Behältnis erhoben wurden oder hieraus abgeleitet sind.

Weiterhin entfällt hierdurch vorteilhaft ein halbautomatisches oder manuelles Erlernen der Flaschenkontur, etwa bei einer Flaschensortierung oder einer Fremdflaschenerkennung, bzw. ein halbautomatisches oder manuelles Erlernen der Abwicklung, etwa bei einer 360°-Etikettenkontrolle.

Das vorgeschlagene Verfahren bietet weiterhin den Vorteil einer einfachen Nachrüstung von neuen Flaschensorten beim Kunden bzw. beim Betreiber der Vorrichtung zum Inspizieren von Behältnissen. Eine Nachrüstung kann durch Ersetzen der Daten des vorherigen Modells der alten Behältnissorte durch Daten eines Modells des Behältnisses der neuen Behältnissorte vorgenommen werden. Auch beim Nachrüsten kann daher ein zeitaufwändiges Einlernen der neuen Flaschensorte vermieden werden.

Weiterhin können vorteilhaft Reklamationen vermieden werden.

Bevorzugt handelt es sich bei dem Modell des Behältnisses um ein (rein rechnergestützt erzeugtes), insbesondere dreidimensionales, Konstruktionsmodell des Behältnisses, und besonders bevorzugt um ein Modell, welches dazu konstruiert wurde, um (zumindest mittelbar) das (zu inspizierende) Behältnis zu erzeugen. Beispielsweise kann es sich bei dem Modell um ein CAD-Modell handeln (CAD Abkürzung für engl. "computer-aided design", dt. rechnergestütztes Konstruieren). Denkbar ist auch, dass es sich bei den Daten des Modells um (insbesondere einzig) von dem Konstruktionsmodell abgeleitete Daten bzw. um ein rein mittels rechnerbasierter Konstruktion erzeugter Daten handelt, welche insbesondere keine mittels Erfassung eines realen Behältnisses oder Objekts erzeugte Daten aufweist. Bei dem Modell könnte es sich um ein Drahtmodell, ein Flächenmodell und/oder ein Volumenmodell und/oder ein Dreiecksnetz handeln.

Bevorzugt können Daten, welche zum Design bzw. zur Entwicklung des Behältnisses und/oder zur Herstellung einer Behältniserzeugungs- und/oder Behältnisbehandlungsvorrichtung verwendet werden. Beispielsweise könnten für die Daten des Modells des zu inspizierenden Behältnisses die Daten eines diesem Behältnis zugeordneten Modells verwendet werden, welche beispielsweise zur Herstellung von Blasformen für dieses Behältnis für eine Blasform-Maschine und/oder zur Herstellung einer Spritzgussform zum Spritzgießen von diesem Behältnis entsprechenden Kunststoffvorformlingen, benötigt werden. So entspricht etwa die Innenkontur der Blasformen für eine Blasform-Maschine der Außenkontur der hieraus herzustellenden Behältnisse.

Denkbar ist auch, dass die Daten des Modells neben Daten eines virtuellen Modells (etwa einem CAD-Modell) auch Daten eines realen Modells bzw. durch Erfassung eines realen Objekts bzw. Behältnisabschnitts erzeugte Daten wie beispielsweise photorealistische Daten enthält. Beispielsweise könnten die Daten des Modells zusammengesetzt sein (unter anderem oder ausschließlich) aus Daten eines 3D-CAD-Modells eines Behältnisses und photorealistischen Daten in Bezug auf ein Etikett des Behältnisses.

Bevorzugt ist eine Datenbank vorgesehen, auf welcher jeweils Daten eines Modells einer Vielzahl von Behältnissen abgelegt sind. Die Datenbank kann dabei auf einer in Bezug auf die Vorrichtung zum Inspizieren der Behältnisse externen und/oder nicht-flüchtigen Speichereinrichtung abgelegt sein. Dabei kann die Speichereinrichtung Cloud-basiert sein. Denkbar ist, dass die Vorrichtung zum Inspizieren von Behältnissen auf die Speichereinrichtung insbesondere über das Internet (und/oder über ein, insbesondere wenigstens abschnittsweise drahtgebundenes und/oder drahtloses, öffentliches und/oder privates Netzwerk) zugreift, um die Daten des Modells abzurufen.

Der externe Server ist beispielsweise ein Backend insbesondere eines Behältnisinspektionsvorrichtungs-Herstellers oder eines Diensteanbieters, wobei der Server dazu eingerichtet ist, Daten des Modells bzw. das Modell des Behältnisses und insbesondere Daten einer Vielzahl von Modellen bzw. eine Vielzahl von Modellen von (insbesondere verschiedenen) Behältnissen zu verwalten.

Das Modell und/oder die Daten des Modells kann dabei auch eine Ausstattung des Behältnisses, wie etwa ein Etikett und/oder einen Verschluss des Behältnisses, oder hierfür charakteristische Daten enthalten.

Bei den Daten des Modells kann es sich um Daten in Bezug auf das gesamte Modell (inklusive dessen Ausstattung und/oder Teile der Ausstattung des Behältnisses oder ohne die Ausstattung des Behältnisses) handeln.

Denkbar ist aber auch, dass es sich bei den Daten des Modells um lediglich Teile (etwa eine Ausstattung) oder Bestandteile oder ein Bereich des Behältnisses, etwa ein Mündungsbereich oder ein Bodenbereich des Behältnisses oder ein Seitenwandungsbereich des Behältnisses, handelt.

Es können also bevorzugt Etiketten des Modells mit realen Etiketten verglichen werden.

Insbesondere handelt es sich bei dem Modell um ein Modell wenigstens eines Bereichs des Behältnisses. Denkbar ist, dass es sich bei dem Modell nicht um ein Modell des gesamten Behältnisses und/oder dessen Ausstattung handelt, sondern um lediglich einen Bereich des

Behältnisses und/oder lediglich eine Ausstattung des Behältnisses handelt. Denkbar ist auch, dass das Modell zusammengesetzt ist aus einer Vielzahl von Modellen verschiedener Bereiche des Behältnisses und/oder verschiedener Ausstattungselemente des Behältnisses. So könnte beispielsweise ein erstes Modell für das Behältnis und ein weiteres Modell für ein Etikett vorgesehen sein. Diese beiden Modelle könnten zusammengefügt werden, um ein Modell für das zu inspizierende Behältnis zu ergeben.

Mit anderen Worten können die Daten des Modells charakteristisch sein für (einschließlich oder ausschließlich) eine Behältnissorte und/oder eine Ausstattung und/oder jede Ausstattung des zu inspizierenden Behältnisses. Denkbar ist auch, dass bei der Auswertung des Bildes lediglich Daten eines Modellabschnitts verwendet werden, welcher insbesondere im Wesentlichen mit dem zu inspizierenden Bereich übereinstimmt.

Bei einem bevorzugten Verfahren handelt es sich bei den Daten des Modells um dreidimensionale Daten, welche für das Modell dieses Behältnisses charakteristisch sind. Dabei kann es sich bei dem Modell um ein (insbesondere rein) mittels einer Anwendung für virtuelle Produktentwicklung erstelltes bzw. erzeugtes Modell, beispielsweise ein CAD-Modell, handeln. Bevorzugt handelt es sich zumindest bereichsweise bei dem Modell um rein virtuell erzeugte Daten und besonders bevorzugt handelt es sich bei dem gesamten Modell des Behältnisses um rein virtuell erzeugte Daten (also etwa um ein mittels einer Anwendung für virtuelle Produktentwicklung erzeugtes Modell).

Dies bietet den Vorteil, dass diese Daten für eine Vielzahl verschiedene Behältniskontrollen oder in verschiedenen Erkennungseinheiten verwendet werden können. Insbesondere bietet dies den Vorteil, dass eine Behältniskontrolle schnell beispielsweise bei Änderung einer Ausstattung umgestellt werden kann, ohne ein wiederholtes aufwändiges, von einem Bediener zumindest zu überwachendes und/oder zu begleitendes Erzeugen eines Modells vornehmen zu müssen.

Bevorzugt sind die Daten des Modells und/oder das Modell charakteristisch für Behältnisparameter, welche ausgewählt sind aus einer Gruppe, die eine (Gesamt-)Höhe des Behältnisses, ein (Boden- und/oder Grundkörper- und/oder Mündungsrand-)Durchmesser des Behältnisses, ein (Nenn-)Volumen des Behältnisses, eine Behältnisgeometrie, insbesondere ein Verlauf des Behältnishalses, einen Bodenbereich, ein Behältniswerkstoff, ein Behältnismaterial (des Grundkörpers und/oder einer Ausstattung des Behältnisses), (wenigstens oder genau) ein dem Behältnis zugeordnetes Füllgut, eine Ausstattung des Behältnisses, ein Verschluss des Behältnisses, ein Mundstück des Behältnisses, eine Etiketten-Zuordnung für das Behältnis, eine Ausstattungs-Zuordnung für das Behältnis und dergleichen sowie Kombinationen hiervon umfasst.

Bei einem bevorzugten Verfahren wird (bevorzugt mittels einer, insbesondere Prozessor-basierten, Modellerstellungseinrichtung) auf Basis der Daten ein Referenzmodell des Behältnisses erstellt, welches zur Auswertung des aufgenommenen Bildes verwendet wird. Bei diesem Referenzmodell des Behältnisses kann es sich um ein dreidimensionales und/oder ein zweidimensionales Modell handeln. So könnte es sich beispielsweise bei dem Referenzmodell um ein Referenzmodell für eine 2D oder 3D Flaschenkontur, oder ein Referenzmodell für eine (wenigstens bereichsweise und/oder bevorzugt vollumfänglich) Abwicklung der Flaschenoberfläche (etwa für eine 360° Etikettenkontrolle) handeln. Denkbar ist auch, dass es sich bei dem zweidimensionalen Referenzmodell um eine Draufsicht und/oder eine perspektivische Ansicht auf das dreidimensionale Modell und/oder einen Querschnitt und/oder eine Projektion und/oder eine Seitenansicht des dreidimensionalen Modells handelt.

Bevorzugt wird das Referenzmodell mit dem aufgenommenen Bild, insbesondere mit den Daten dieses Bildes verglichen.

Bei einem bevorzugten Verfahren wird auf Basis der Daten des Modells automatisch wenigstens eine zur Auswertung des aufgenommenen Bildes zu verwendende Auswertungsgröße ermittelt. Insbesondere kann eine automatische Parametrierung anhand der Daten des Modells vorgenommen und jedes aufgenommene Bild mittels dieser Parametrierung bzw. unter Verwendung der wenigstens einen Auswertungsgröße ausgewertet werden. Bevorzugt kann eine automatische Parametrierung anhand eines 3D-Flaschenmodells erfolgen.

Denkbar ist auch, dass mehrere Auswertungsgrößen ermittelt und zur Auswertung des aufgenommenen Bildes verwendet werden. Die Auswertungsgrößen werden also bevorzugt nur mittels der Daten des Modells ermittelt, ohne Daten eines realen Behältnisses zu verwenden.

Bei der Auswertungsgröße kann es sich dabei um eine Größe handeln, die charakteristisch ist für eine Parametrierung für eine (beabsichtigte) Behältniskontrolle und/oder Ausstattungskontrolle und/oder eine Behältnissortierung, etwa für eine zu überprüfende Kontur (entlang einer bevorzugt vorgegebenen Querschnittsebene in Bezug auf eine vorgegebene räumliche Orientierung des Behältnisses), Wahl einer ROI (Abkürzung für engl. "Region of Interest"; in Deutsch: interessierender Bereich), ein Farbwert oder mehrere Farbwerte und dergleichen.

Dies bietet den Vorteil, dass im Gegensatz zu dem aus dem Stand der Technik bekannten Verfahren nicht erst Daten in Bezug auf ein reales Referenz-Behältnis aufgenommen werden müssen und das aufgenommene Bild des realen Referenz-Behältnisses zur Vornahme einer Parametrierung analysiert und basierend hierauf eine Parametrierung durch einen Nutzer vorgenommen werden muss.

Dagegen wird vorliegend vorgeschlagen, dass auf Basis der Daten des Modells automatisch, und insbesondere ohne erforderliche Benutzereingabe, wenigstens eine und bevorzugt alle zur Auswertung des aufgenommenen Bildes zu verwendenden Auswertungsgrößen ermittelt werden. Denkbar ist aber auch, dass die automatisch ermittelten Auswertungsgrößen einem Benutzer bzw. einem Einrichter vorgeschlagen werden, indem sie beispielsweise mittels einer Ausgabeeinrichtung an den Benutzer bzw. dem Einrichter ausgegeben werden, und der Benutzer bzw. der Einrichter die Auswertungsgröße(n) ändern kann und hierdurch beispielsweise eine Nachjustierung vornehmen kann.

Beispielsweise kann bei einer Behältnissortierung oder einer Behältniskontrolle auf Grundlage einer Behältniskontur bereits vorgegeben sein, dass es sich bei wenigstens einer Auswertungsgröße um eine für eine Behältniskontur charakteristische Größe handelt, welche automatisch basierend auf den Daten des Modells des Behältnisses ermittelt wird. Soll nun das zu inspizierende Behältnis (etwa durch Änderung der Behältnis- und/oder Ausstattungssorte) geändert werden oder beispielsweise eine weitere zu inspizierende Behältnissorte ergänzt werden, kann automatisch basierend auf Daten eines Modells in Bezug auf das geänderte zu inspizierende Behältnis die wenigstens eine (neue) Auswertungsgröße ermittelt werden.

Bevorzugt kann damit (etwa durch einen Einrichter oder einen Bediener) die Art der Auswertung (etwa eine Inspektionsaufgabe) unabhängig von einem spezifischen Behältnis vorgegeben werden. Hierzu kann (etwa durch einen Einrichter oder einen Bediener, beispielsweise durch auf einer insbesondere nicht-flüchtigen Speichereinrichtung ablegbare Anweisungen zur Verarbeitung der Daten des Modells des Behältnisses, insbesondere in änderbarer Weise) vorgegeben werden, auf welche Weise eine Auswertungsgröße basierend auf vorgegebenen Daten eines Modells des zu inspizierenden Behältnisses ermittelt wird. Dies bietet den Vorteil, dass bei Umstellung einer Behältnissorte eine entsprechende Bildauswertung (durch Änderung der Daten des Modells) automatisch mit anpassbar ist.

Bevorzugt wird die Auswertungsgröße bzw. werden die Auswertungsgrößen auf einer nicht-flüchtigen Speichereinrichtung abgelegt. Bevorzugt ist die nicht-flüchtige Speichereinrichtung (insbesondere fester und/oder nicht zerstörungsfrei lösbarer) Bestandteil der Bildauswerteeinrichtung. Denkbar ist aber auch, dass eine, insbesondere (wenigstens teilweise oder in ihrer Gesamtheit) drahtlose und/oder (wenigstens teilweise oder in ihrer Gesamtheit) drahtgebundene Datenübertragungseinrichtung vorgesehen ist, mittels welcher von der Speichereinrichtung die Auswertungsgrößen und/oder die Daten des Modells des Behältnisses an die Bildauswerteeinrichtung übermittelt werden (bzw. übermittelbar sind).

Bei einem bevorzugten Verfahren wird (wenigstens) eine synthetische Aufnahme eines (2D- und/oder) 3D- Modells des Behältnisses an einer vorgegebenen, insbesondere (von einem Einrichter oder einem Bediener) wählbaren, Position im Raum erstellt. Bevorzugt wird eine Vielzahl derartiger synthetischer Aufnahmen erstellt und insbesondere zur Auswertung des aufgenommenen Bildes verwendet.

Bevorzugt kann (von einem Einrichter oder einem Bediener) ein Inspektionsbereich und insbesondere eine Inspektionsposition (insbesondere in Bezug auf die Transporteinrichtung und/oder die Bildaufnahmeeinrichtung(en) und/oder in Bezug auf ein Weltkoordinatensystem) festgelegt bzw. eingestellt werden. Bevorzugt wird die synthetische Aufnahme in Abhängigkeit der Position im Raum und/oder des Inspektionsbereichs und/oder der Inspektionsposition erstellt.

Bevorzugt wird die (wenigstens eine) synthetische Aufnahme (oder die Vielzahl an synthetischen Aufnahmen) wenigstens abschnittsweise und/oder als Berechnungsgrundlage für das Referenzmodell und/oder zur Auswertung des aufgenommenen Bildes verwendet.

Bevorzugt ist wenigstens ein Bilderzeugungsparameter und besonders bevorzugt ist eine Vielzahl von Bilderzeugungsparametern zur Erzeugung der wenigstens einen synthetischen Aufnahme bzw. der Vielzahl synthetischer Aufnahmen (von einem Einrichter bzw. einem Bediener) vorgebbar bzw. einstellbar. Beispielsweise kann eine Eingabeeinrichtung vorgesehen sein, über welche diese Bilderzeugungsparameter eingegeben oder ausgewählt werden können.

Bei dem Bilderzeugungsparameter kann es sich um einen Beleuchtungsparameter wie beispielsweise eine Anzahl an Beleuchtungseinrichtungen (etwa Anzahl der Lichtquellen) und/oder eine (jeweilige) Position und/oder ein emittiertes Lichtspektrum und/oder ein Beleuchtungsbereich und/oder eine Beleuchtungsart und/oder ein Beleuchtungswinkel einer (insbesondere virtuellen) Beleuchtungseinrichtung (etwa einer Lichtquelle) handeln.

Bei dem Bilderzeugungsparameter kann es sich um einen Bildaufnahmeparameter wie eine Art (etwa schwarz/weiß oder farbig) und/oder eine Anzahl und/oder eine Position und/oder einen (jeweiligen) Aufnahmewinkel und/oder eine Aufnahmerichtung und/oder einen Sichtbereich einer (insbesondere virtuellen) Beleuchtungseinrichtung handeln.

So kann etwa mittels der Bilderzeugungsparameter eingestellt werden, von welchen und von wie vielen Beleuchtungseinrichtungen das (virtuelle) Behältnis beleuchtet und von welchen virtuellen Kameras und von wo ein synthetisches Bild des (virtuellen) Behältnisses erzeugt wird.

Dies bietet den Vorteil, dass durch die Wahl der Bilderzeugungsparameter der Aufbau und die Art der Bildaufnahme der Inspektionseinrichtung nachgebildet werden kann. Dadurch kann vorteilhaft das synthetische Bild zum insbesondere direkten Vergleich mit dem aufgenommenen Bild der Inspektionseinrichtung verwendet werden, insbesondere ohne einer Reskalierung und/oder (perspektivischen) Verzerrung bzw. Entzerrung.

Bevorzugt wird basierend auf den Daten des Modells des Behältnisses wenigstens ein Bild gerendert, wobei das gerenderte Bild zur Auswertung des aufgenommenen Bildes verwendet wird. Bevorzugt erfolgt das Rendern auf Grundlage von (vorgegebenen und bevorzugt von einem Bediener wählbaren oder vorgebbaren) Materialparametern (in Bezug auf das Behältnis und/oder eine Ausstattung des Behältnisses) und/oder wenigstens einem oder einer Vielzahl von Bilderzeugungsparametern (wie etwa die obig genannten Bildbeleuchtungsparameter und/oder Bildaufnahmeparameter, z.B. Anzahl und Position der Lichtquellen).

Bevorzugt kann (zur Erzeugung eines gerenderten Bildes) eine (synthetische und/oder perspektivische) Aufnahme bzw. ein Bild aus einer (vorgegebenen oder von einem Bediener vorgebbaren bzw. wählbaren) 3D-Szene generiert werden und zur Auswertung des Bildes verwendet werden. Bevorzugt kann eine (virtuelle) Transporteinrichtung und/oder weitere (virtuelle) Bestandteile der Inspektionseinrichtung Teil der 3D-Szene sein.

Denkbar ist auch, dass ein fotorealistisches (insbesondere zweidimensionales) Hintergrundbild zur Erzeugung des (synthetischen und/oder gerenderten) Bildes verwendet wird. Dabei kann eine möglichst realitätsnahe Darstellung eines durch die Bildaufnahmeeinrichtung aufgenommene Hintergrunddarstellung erreicht werden.

Bevorzugt wird ein künstliches Bild des 3D - Modells mit den Parametern der Kamera erzeugt (und zur Auswertung des aufgenommenen Bildes verwendet). Man erhält ein künstliches Bild mit all den gleichen Effekten (Linsenverzerrung etc...) als wäre das Bild wirklich mit der Kamera gemacht worden.

Bevorzugt wird basierend auf den Daten des Modells des Behältnisses eine realitätsnahe Darstellung und/oder eine möglichst foto-realitätsnahe Darstellung des Modells erzeugt, welche bevorzugt als Referenzmodell zur Auswertung des aufgenommenen Bildes verwendet wird. Hierzu kann das Modell des Behältnisses (insbesondere auf Grundlage von vorgebbaren Texturparametern) texturiert werden. Bevorzugt basiert die Auswertung des Bildes auf Grundlage einer (wenigstens abschnittsweise) Texturierung des Modells des Behältnisses. Insbesondere wird hierzu auf Grundlage der Daten des Modells und bevorzugt auf Grundlage weiterer Texturparameter wenigstens ein Texturbild erzeugt. Dabei kann zur Texturierung eine foto-realistische und/oder eine synthetische Textur verwendet werden.

Eine derartige Texturierung bietet den Vorteil, dass auch weniger detailreiche 3D-Modelle möglichst realistisch dargestellt werden können und somit in besonders recheneffizienter und damit in besonders schneller Weise mit dem auszuwertenden aufgenommenen Bild verglichen werden können. Dies ist insbesondere von wesentlicher Bedeutung, da bevorzugt eine Transporteinrichtung verwendet wird, die wenigstens 5000 zu inspizierende Behältnisse pro Stunde (zur Bildaufnahmeeinrichtung hin und von dieser weg) transportiert bzw. hierzu geeignet und bestimmt ist.

Bevorzugt umfassen die Daten des Modells des Behältnisses eine für eine Ausrichtung (bzw. Orientierung) des Behältnisses charakteristische Größe. Bevorzugt wird zur Auswertung des aufgenommenen Bildes die Ausrichtung des Behältnisses berücksichtigt. Beispielsweise kann das Modell des Behältnisses, insbesondere in Abhängigkeit von dessen Ausrichtung, transformiert, wie beispielsweise translatiert, skaliert, rotiert und/oder auch deformiert (z.B. verjüngt, verdreht, geschert und dergleichen) werden.

Bevorzugt wird zur Auswertung des Bildes die Ausrichtung des Modells des Behältnisses mit einer Ausrichtung des zu inspizierenden Behältnisses (in Bezug auf die Transporteinrichtung und/oder einer Kameraposition und/oder der Kameraausrichtung) verglichen.

Bevorzugt wird die Ausrichtung (bzw. die Orientierung) des Modells und die Ausrichtung des inspizierten Behältnisses bzw. des hiervon aufgenommenen Bildes aneinander angeglichen. Insbesondere müssen sich zur Auswertung des aufgenommenen Bildes das (3D-)Modell und die Orientierung (bzw. die Ausrichtung) der dazugehörigen (bzw. der aufgenommenen) Bilder auf dasselbe Koordinatensystem beziehen.

Denkbar ist beispielsweise, dass die Daten des Modells derart (insbesondere vor der Vornahme der Auswertung) verarbeitet werden, dass die Orientierung bzw. Ausrichtung des Modells an die Orientierung bzw. Ausrichtung des zu inspizierenden Behältnisses oder dem von diesem aufgenommenen Bild angepasst und insbesondere in Übereinstimmung gebracht wird.

Damit kann ein im Wesentlichen unmittelbarer Vergleich des aufgenommenen Bildes mit den Daten des Modells erfolgen.

Für die korrekte Abbildungsgröße im Kamerabild erfolgt bevorzugt eine Kalibierung Pixel pro Millimeter.

Bei einem bevorzugten Verfahren wird eine Kalibrierung der Bildaufnahme bzw. des aufgenommenen Bildes, insbesondere eine Größenkalibrierung, vorgenommen. Bevorzugt kann auf Grundlage der vorgenommenen Kalibrierung eine im Wesentlichen (korrekte bzw. reale) Abbildungsgröße im aufgenommenen Bild ermittelt werden. Beispielsweise kann durch eine Kalibrierung ein Abbildungsmaßstab der Bildaufnahmeeinrichtung ermittelt werden. So kann etwa durch die Kalibrierung ermittelt werden, welcher realen Ausdehnung eine (vorgegebene) Anzahl von Pixeln eines in dem aufgenommenen Bild abgebildeten Objekts (wie das Behältnis) entspricht.

Bevorzugt kann auf Grundlage der Kalibrierung wenigstens eine räumliche bzw. geometrische Ausdehnungsgröße (wie etwa eine Höhe und/oder eine Breite und/oder ein Durchmesser) des Behältnisses aus dem aufgenommenen Bild des Behältnisses ermittelt werden.

Eine Kalibrierung kann dabei insbesondere auf mehreren Wegen erfolgen:
Bevorzugt wird zur Kalibrierung ein (vorgegebener) Kalibierkörper verwendet, von welchem bevorzugt eine zu interessierende Ausdehnungsgröße wie etwa eine Höhe bekannt ist. Bevorzugt nimmt dabei die Bildaufnahmeeinrichtung (z.B. die Kamera) ein Bild von dem Kalibrierkörper auf. Durch Auswertung mit der jeweiligen Bildaufnahmeeinrichtung (z.B. Kamera) und insbesondere durch vergleich des in dem aufgenommenen Bild abgebildeten Kalibrierkörpers mit der Ausdehnungsgröße bzw. mit der Dimension des realen Kalibrierkörpers kann ein Abbildungsmaßstab (insbesondere in Bezug auf eine vorgegebene relative Anordnung der Bildaufnahmeeinrichtung und eines zu inspizierenden Behältnisses) ermittelt werden.

Denkbar ist, dass die Daten des Modells des Behältnisses und/oder (umgekehrt) das aufgenommene Bild (wenigstens bereichsweise) basierend auf der Kalibrierung und/oder auf Grundlage des ermittelten Abbildungsmaßstabes skaliert wird.

Zusätzlich oder alternativ kann zur Kalibrierung ein Vergleich von dem aufgenommenen Bild bzw. dem Realbild und der (3D-)Daten (des Modells), bevorzugt in der Höhe, vorgenommen werden. Bevorzugt wird beispielsweise ein Realbild einer realen Flasche mit der Erkennungseinheit (bzw. Bildaufnahmeeinrichtung) aufgenommen und dann die Idealwerte der 3D Flaschenzeichnung bevorzugt in der Höhe "aufgezoomt".

Zusätzlich oder alternativ kann eine Kalibrierung auf Grundlage einer Messung von typischen Merkmalen (z.B. Transportbandkette) als Referenzwert vorgenommen werden. Bevorzugt wird zur Kalibrierung mit der Bildaufnahmeeinrichtung ein Bild eines Elements (beispielsweise der Transporteinrichtung) der Inspektionseinrichtung aufgenommen. Das aufgenommene Bild wird bevorzugt mit einer (vorgegebenen oder gemessenen) Ausdehnungsgröße des (realen) Elements verglichen und bevorzugt hieraus ein Abbildungsmaßstab ermittelt, welcher zur Kalibrierung verwendet werden kann und insbesondere verwendet wird. Dabei kann es sich bei dem Element bevorzugt um ein bei der Aufnahme des Bildes des inspizierten Behältnisses ebenfalls (wenigstens teilweise) abgebildetes Element der Inspektionseinrichtung handeln. Beispielsweise kann es sich um ein Element der Inspektionseinrichtung handeln, welches in dem Hintergrund des aufgenommenen Bildes sichtbar ist.

Bei einem bevorzugten Verfahren wird eine kalibrierte Bildaufnahmeeinrichtung (z.B. Kamera) verwendet. Denkbar ist auch, dass eine Kalibrierung der Bildaufnahmeeinrichtung vorgenommen wird. Bevorzugt kann aus der Kalibrierung der Bildaufnahmeeinrichtung (und/oder durch die Kalibrierung der Bildaufnahmeeinrichtung) eine Position und insbesondere eine relative Anordnung und/oder eine relative Ausrichtung zwischen der Bildaufnahmeeinrichtung und dem zu inspizierenden und/oder dem inspizierten Behältnis (insbesondere zum Bildaufnahmezeitpunkt) abgeleitet werden. Besonders bevorzugt kann eine Position der Bildaufnahmeeinrichtung im Weltkoordinatensystem ermittelt werden.

Dies bietet den Vorteil, dass hieraus eine Ausrichtung bzw. eine Orientierung des in dem aufgenommenen Bild abgebildeten Behältnisses ermittelt werden kann. Hieraus kann basierend auf einer vorgegebenen und insbesondere auf einer vorbekannten Ausrichtung bzw. Orientierung des Modells des Behältnisses eine präzisere Auswertung des aufgenommenen Bildes vorgenommen werden, da die Größenverhältnisse und/oder die relativen Ausrichtungen zwischen dem inspizierten Behältnis (bzw. des abgebildeten Behältnisses in dem aufgenommenen Bild) und dem Modell des Behältnisses (bzw. den Daten des Modells) bei der Auswertung des aufgenommenen Bildes berücksichtigt werden können. Hierdurch ist ein besserer und einfacherer pixelweiser bzw. bereichsweiser Vergleich des aufgenommenen Bildes und beispielsweise eines basierend auf den Daten des Modells ermittelten (synthetischen) Bildes möglich.

Bevorzugt ist durch Verwendung einer kalibrierten Bildaufnahmeeinrichtung (z.B. Kamera) die Position der Bildaufnahmeeinrichtung (z.B. Kamera) im Weltkoordinatensystem bekannt und es kann beispielsweise eine synthetische Aufnahme des (3D-)Modells des Behältnisses an jeder beliebigen Position im Raum erstellt werden. Die daraus gewonnene Kontur kann dann beispielsweise als Referenz dienen.

Bei einem bevorzugten Verfahren wird eine Kalibrierung des auf Basis der Daten ermittelten (Referenz-)Modells gegenüber dem aufgenommenen Bild ermittelt.

Bevorzugt wird auf Basis der Kalibrierung und/oder eines auf Grundlage der Kalibrierung ermittelten Abbildungsmaßstab und/oder relativen (Winkel- und/oder Abstands-)Anordnung zwischen dem (realen) inspizierten Behältnis und dem in dem aufgenommenen Bild abgebildeten Behältnis eine perspektivische Verzerrung und/oder Rotation und/oder Skalierung des abgebildeten Behältnisses und/oder der Daten des Modells und/oder des Referenzmodells und/oder des Modells vorgenommen. Bevorzugt wird dabei auch die Ausrichtung und/oder die Größe des Modells des Behältnisses berücksichtigt.

Bei einem bevorzugten Verfahren wird zur Auswertung des aufgenommenen Bildes (insbesondere beispielsweise als Auswertungsgröße) eine gegenüber räumlichen Operationen, insbesondere gegenüber Skalierungen, Rotationen und/oder Translationen, invariante Größe des Modells des Behältnisses verwendet. Dies bietet den Vorteil, dass keine Kalibrierung (etwa der Bildaufnahmeeinrichtung) erforderlich ist. So kann beispielsweise eine Kontur des Behältnisses direkt aus dem 3D-Modell erzeugt werden und diese durch geeignete Methoden, welche invariant gegenüber Skalierungen, Rotation und Translation sind, ausgewertet werden. Hierfür ist keine Kalibrierung nötig. Die Konturerkennung wäre ein Beispiel hierfür.

Bei einem bevorzugten Verfahren gibt die Inspektionseinrichtung wenigstens einen Wert aus, der für das inspizierte Behältnis charakteristisch ist. Dabei kann es sich um einen Wert für eine Kontur, z.B. zur Fremdbehältniserkennung, einen Wert für eine Behältnissorte, ein Wert für ein Etikett und/oder für eine Etikettenkontrolle, ein Wert für eine Ausstattung, ein Wert für eine Ausstattungskontrolle, ein Wert für eine Mündung, ein Wert für eine Seitenwand, Kontrollergebnisse hierfür und Kombinationen hiervon handeln. Dies bietet den Vorteil, dass aus diesem Wert ein weiterer Behandlungsschritt des Behältnisses (wie beispielsweise ein Ausleiten und/oder ein Verpacken) abgeleitet werden kann.

Bei einem bevorzugten Verfahren wird durch die Bildauswertung eine Behältnissortierung und/oder eine Behältniskontrolle durchgeführt, welche aus einer Gruppe von Behältniskontrollen (bzw. Inspektionsaufgaben) ausgewählt ist, welche eine Fremdbehältniserkennung, eine Ausstattungskontrolle, eine Etikettenkontrolle, eine Mündungskontrolle, eine Seitenwandinspektion, eine Seitenwanderkennung von Kunststoffvorformlingen und dergleichen enthält.

Denkbar ist dabei auch, dass (zusätzlich oder alternativ) eine Kontur des inspizierten Behältnisses mittels Fehlbelichtung ("Überstrahlen") mittels der Inspektionseinrichtung ermittelt wird.

Bei einem bevorzugten Verfahren werden aus den Daten Dimensionen für eine 360° - Abwicklung des Behältnisses gewonnen, wobei bevorzugt diese Dimensionen aus einer Gruppe von Dimensionen ausgewählt sind, welche eine Höhe des Behältnisses, einen Durchmesser des Behältnisses, einen Mündungsquerschnitt des Behältnisses, eine seitliche Kontur des Behältnisses eine seitliche Kontur eines Mündungsbereiches des Behältnisses eine seitliche Kontur eines Halses des Behältnisses und/oder dergleichen sowie Kombinationen hiervon enthält.

Die daraus gewonnene Kontur kann dann als Referenz dienen. So kann etwa das aufgenommene Bild mittels der gewonnenen Kontur als Referenz ausgewertet werden, indem beispielsweise eine aus dem aufgenommenen Bild ermittelte (zur Referenz-Kontur korrespondierende) Kontur mit der gewonnen (Referenz-)Kontur verglichen wird.

Bei einem bevorzugten Verfahren werden die Daten aus einer Speichereinrichtung in die Auswerteeinrichtung geladen. Bei der Speichereinrichtung kann es sich dabei insbesondere um eine Speichereinrichtung gemäß einer obig beschriebenen Ausführungsform handeln.

Denkbar ist, dass auf der Speichereinrichtung eine Vielzahl von Modellen von (jeweils einander unterschiedlichen) Behältnissen (in der Datenbank) abgelegt ist. Denkbar ist, dass die Bildauswerteeinrichtung auf Grundlage des aufgenommenen Bildes, insbesondere automatisch, (genau) ein Modell bzw. die Daten des Modells aus der Vielzahl von Modellen auswählt und basierend hierauf eine Auswertung des Bildes (zur Ermittlung eines für das inspizierte Behältnis charakteristischen Werts) vornimmt.

Es ist denkbar, dass auf Grundlage des aufgenommenen Bildes eine (automatische) Zuordnung von Daten eines Modells (bzw. des Modells) aus einer Vielzahl von Modellen (bzw. Daten einer Vielzahl von Modellen) erfolgt. Mit anderen Worten wird bevorzugt aus dem aufgenommenen Bild (genau) ein Modell ermittelt und/oder identifiziert, welches besonders bevorzugt in Folge zur Auswertung des Bildes herangezogen wird.

Denkbar ist aber (zusätzlich oder alternativ) auch, dass ein Bediener, insbesondere über eine Eingabeeinrichtung, eine Auswahl (genau eines Modells) oder eine Vorauswahl mehrerer Modelle aus der Vielzahl von abgelegten Modellen vornimmt. Denkbar ist, dass eine derartige (Vor-)Auswahl die Übertragung bzw. das Laden der Daten des jeweiligen Modells bzw. der jeweiligen Modelle in die Bildauswerteeinrichtung auslöst. Bei der Eingabeeinrichtung kann es sich dabei um eine stationäre oder mobile Eingabeeinrichtung, welche sich am Ort der Inspektionseinrichtung befindet, handeln. Denkbar ist aber auch, dass sich die Eingabeeinrichtung an einem anderen Ort und insbesondere nicht in derselben Halle wie die Inspektionseinrichtung befindet und der Bediener mittels Fernzugriff (remote control) eine Auswahl des Modells und/oder ein Laden bzw. ein Übertragen des Modells und/oder eines von der Inspektionseinrichtung vorzunehmende Inspektionsaufgabe auslöst bzw. einstellt.

Bei einem bevorzugten Verfahren werden die Objektpunkte des 3D - Modells zurück in die Bildaufnahmeeinrichtung (z.B. Kamera) projiziert und bevorzugt wird einem Objektpunkt ein charakteristischer Wert und insbesondere ein (insbesondere echter) Farbwert zugeordnet. So kann man dem 3D - Modell die echte Farbe geben und beispielsweise eine Abwicklung davon erzeugen (360° ETK).

Bei einem bevorzugten Verfahren wird eine Kontur des Behältnisses aus einem 3D- Modell des Behältnisses erzeugt. Diese kann beispielweise zur Auswertung des aufgenommenen Bildes, etwa mittels pixelweisen und/oder abschnittsweisen Vergleich) verwendet werden. Die Verwendung einer Kontur des Behältnisses bietet insbesondere bei (im Wesentlichen) rotationssymmetrischen Behältnissen den Vorteil, dass diese Größe invariant ist gegenüber Rotationen des Behältnisses (um dessen Längsachse).

Die vorliegende Erfindung ist weiterhin auf eine Vorrichtung zum Inspizieren von Behältnissen mit einer Transporteinrichtung, welche die Behältnisse entlang eines vorgegebenen Transportpfads transportiert und mit einer Inspektionseinrichtung, welche die Behältnisse inspiziert, wobei die Inspektionseinrichtung eine Bildaufnahmeeinrichtung aufweist, welche wenigstens ein ortsaufgelöstes Bild eines zu inspizierenden Behältnisses aufnimmt und eine Bildauswerteeinrichtung vorgesehen ist, welche dieses Bild auswertet.

Erfindungsgemäß verwendet die Bildauswerteeinrichtung zur Auswertung dieses Bildes Daten eines Modells dieses Behältnisses.

Bevorzugt ist eine Datenübermittlungseinrichtung vorgesehen, welche diese Daten der Bildauswerteeinrichtung (bevorzugt wenigstens abschnittsweise über ein privates Netzwerk und/oder öffentliches Netzwerk, wie das Internet) zuführt.

Die Vorrichtung zum Inspizieren von Behältnissen kann dabei dazu konfiguriert, geeignet und/oder bestimmt sein, alle obig im Zusammenhang mit dem Verfahren zum Inspizieren von Behältnissen beschriebenen Verfahrensschritte bzw. Merkmale einzeln oder in Kombination miteinander auszuführen. Umgekehrt kann das obig beschriebene Verfahren, insbesondere kann die im Rahmen des Verfahrens beschriebene Vorrichtung zum Inspizieren von Behältnissen, alle im Zusammenhang mit der Vorrichtung beschriebenen Merkmale einzeln oder in Kombination miteinander aufweisen und/oder verwenden.

In einer vorteilhaften Ausführungsform weist die Vorrichtung eine, insbesondere Prozessor-basierte, Modellerstellungseinrichtung auf, welche unter Verwendung der Daten ein dreidimensionales Modell eines Referenzbehältnisses erstellt. Bevorzugt wird das dreidimensionale Modell und/oder (zweidimensionale) Projektionen oder Schnitte oder Ansichten dieses dreidimensionales Modells zur Auswertung des aufgenommenen Bildes (etwa mittels Vergleich) verwendet.

Es wird also auch im Rahmen der erfindungsgemäßen Vorrichtung vorgeschlagen, dass eine automatische Parametrierung bzw. ein automatisches Einrichten einer Bildauswertung und/oder ein automatisches Einrichten einer von der Vorrichtung vorzunehmenden Inspektionsaufgabe (insbesondere ausschließlich) anhand von Daten eines Modells des Behältnisses erfolgt. Insbesondere wird kein reales Bild zur Erzeugung eines Referenzmodells (zur Vornahme der Bildauswertung weiterer Behältnisse) verwendet. Daher sind insbesondere in der Bildauswertevorrichtung oder einer hiermit zum Datenaustausch verbundenen Speichereinrichtung keine Daten eines realen Behältnisses zur Verwendung als Referenzmodell für eine Bildauswertung inspizierter Behältnisse abgelegt.

Die vorliegende Erfindung ist weiterhin gerichtet auf ein Computerprogramm oder Computerprogrammprodukt, umfassend Programmmittel, insbesondere einen Programmcode, welcher zumindest einzelne Verfahrensschritte des erfindungsgemäßen Verfahrens, insbesondere die mittels der Modellerstellungseinrichtung und/oder der Bildauswerteeinrichtung ausgeführten Verfahrensschritte, und bevorzugt eine der beschriebenen bevorzugten Ausführungsformen repräsentiert oder kodiert und zum Ausführen durch eine Prozessoreinrichtung ausgebildet ist.

Die vorliegende Erfindung ist weiterhin gerichtet auf einen Datenspeicher, auf welchem zumindest eine Ausführungsform des erfindungsgemäßen Computerprogramms oder einer bevorzugten Ausführungsform des Computerprogramms gespeichert ist.

Weitere Vorteile und Ausführungsformen ergeben sich aus den beigefügten Zeichnungen: Darin zeigen:
- Fig. 1: eine schematische Darstellung einer Vorrichtung zum Inspizieren von Behältnissen gemäß einer erfindungsgemäßen Ausführungsform;
- Fig. 2: eine Darstellung eines Modells eines Behältnisses sowie einer Daten-bank, in welcher die Daten der Modelle mehrerer Behältnisse abgelegt sind;
- Fig. 3: eine Darstellung eines Modells eines Behältnisses zusammen mit einer Ausrichtung des Modells; und
- Fig. 4: ein aufgenommenes Bild zur Veranschaulichung der Auswertung dieses Bildes.

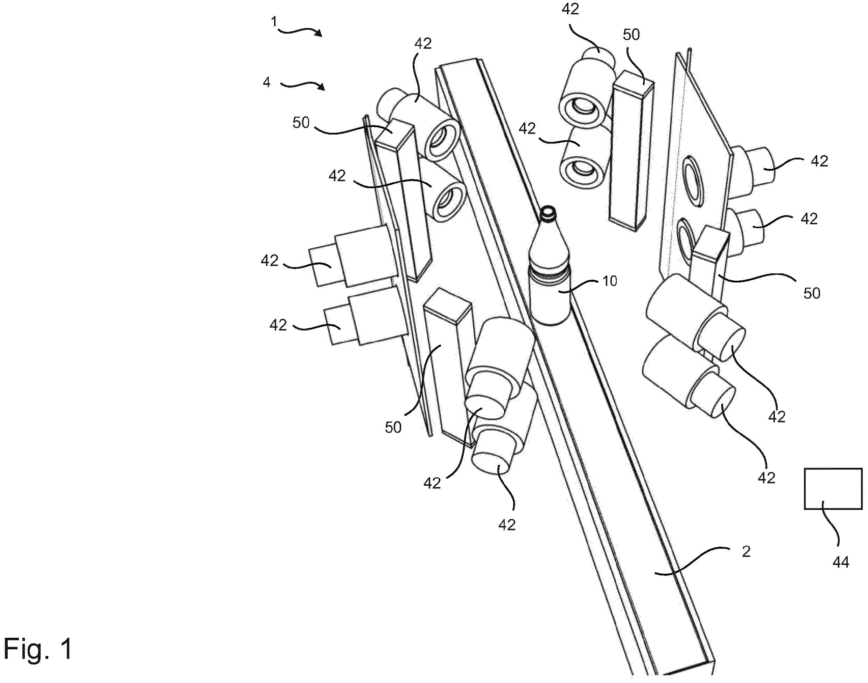

Fig. 1 zeigt eine Vorrichtung 1 zum Inspizieren von Behältnissen 10 gemäß einer erfindungsgemäßen Ausführungsform. Das Bezugszeichen 2 kennzeichnet dabei eine Transporteinrichtung, welche die zu inspizierenden Behältnisse 10 entlang eines (vorgegebenen) Transportpfads zur Inspektionseinrichtung 4 führt und hier von dieser abführt.

Die Inspektionseinrichtung 4 kann dabei eine oder mehrere Bildaufnahmeeinrichtungen 42, wie etwa Kameras, aufweisen. In Figur 1 sind beispielsweise 12 Bildaufnahmeeinrichtungen angeordnet, welche hier auf zwei verschiedenen Inspektionsebenen angeordnet sind, wobei die Bildaufnahmeeinrichtungen der einen Inspektionsebene Bilder eines unteren Behältnisbereichs aufnehmen, während die Bildaufnahmeeinrichtungen 42 der weiteren Inspektionsebene Bilder eines oberen Behältnisbereichs eines zu inspizierenden Behältnisses 10 aufnehmen.

Die Bildaufnahmeeinrichtungen 42 können derart angeordnet sein, dass mehrere oder alle dieser Bildaufnahmeeinrichtungen 42 jeweils wenigstens ein Bild des zu inspizierenden Behältnisses aufnehmen, während sich dieses im Wesentlichen in wenigstens einer Inspektionsposition befindet oder während sich dieses in einem (fest) vorgegebenen Inspektionsbereich befindet. Bevorzugt ist das zu inspizierende Behältnis während der Aufnahme des Bildes durch die Bildaufnahmeeinrichtung(en) 42 in (Transport-)Bewegung. Bevorzugt wird die Transportgeschwindigkeit des zu inspizierenden Behältnisses 10 zur Bildaufnahme nicht oder nicht wesentlich reduziert und insbesondere wird das Behältnis hierzu auch nicht angehalten.

Weiterhin weist die Vorrichtung 1 eine, insbesondere Prozessor-basierte, Bildauswerteeinrichtung 44 auf, welche das aufgenommene Bild auf Grundlage von Daten eines Modells des Behältnisses 10 auswertet.

Die Vorrichtung 1 kann weiterhin wenigstens eine oder mehrere Beleuchtungseinrichtung(en) 50 zur Beleuchtung des zu inspizierenden Behältnisses aufweisen.

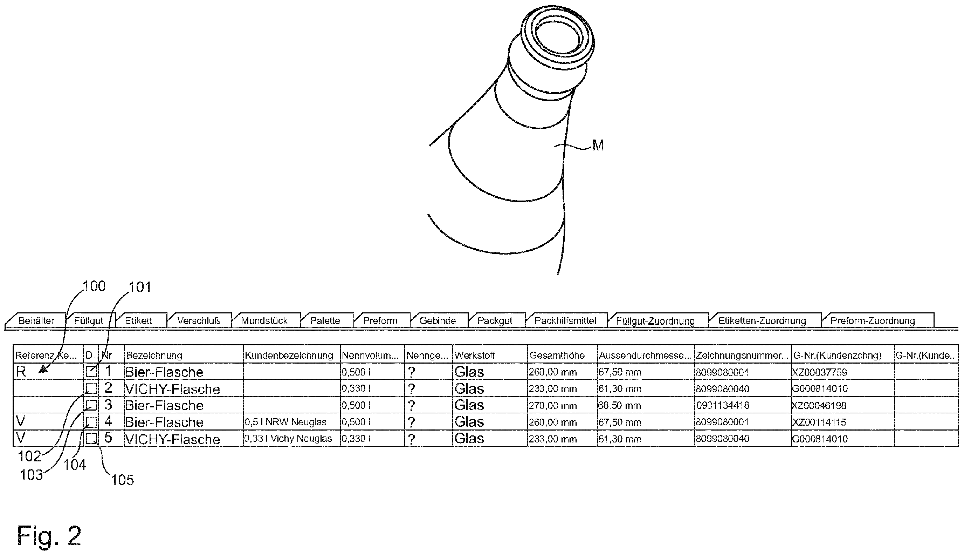

Fig. 2 zeigt eine Darstellung eines Modells M eines Behältnisses 10 sowie einer Datenbank, in welcher die Daten der Modelle mehrerer Behältnisse abgelegt sind. So können etwa in einer Datenbank, etwa einer SAP-Datenbank, (verfügbare) Daten eines Modells eines Behältnisses abgelegt sein. Beispielsweise könnte es sich um die Datenbank eines Blasmaschinen- und/oder eines Blasformherstellers und/oder eines Inspektionseinrichtungsherstellers oder eines Diensteanbieters hiervon handeln, in welcher etwa Kundenobjekte (etwa zur Verwaltung) in Form von 3D-Modellen abgelegt sind.

So können etwa Flaschen, die digital und insbesondere in 3D vorliegen, direkt in die Auswertesoftware eingespielt (bzw. an die Bildauswerteeinrichtung übertragen werden) und bevorzugt in den jeweiligen Erkennungseinheiten verarbeitet werden.

Typische Erkennungen können dabei sein:
- Kontur zur Flaschensortierung und/oder Fremdflaschenerkennung;
- Seitenwandinspektion
   Die aktuelle Seitenwandinspektion setzt das Auswertebild aus mehreren Ansichten zusammen. Dazu ist im ersten Schritt aber immer eine Kontur mittels Fehlbelichtung, ("Überstrahlen"), zu ermitteln. Mit den idealen Daten ist die Ermittlung der Kontur und/oder des Auswertebilds deutlich genauer und mit weniger Fehlern behaftet.
- 360°-Etikettenkontrolle
   Die korrekten Dimensionen des Behälters (Höhe, Durchmesser, seitliche Kontur) für die folgende 360°-Abwicklung können direkt aus den 3D-Daten gewonnen werden.
- Preform-Seitenwanderkennung
   Diese Preformen liegen auch in 3D vor und können genauso als Zielkontur in die Auswertesoftware geladen werden.

Das "Laden" eines Modells oder Daten eines (oder mehrerer Modelle) eines Behältnisses erfolgt insbesondere durch eine entsprechende Softwarebibliothek wie Halcon, PatMax (Cognex) usw. Diese Software verarbeitet die 3D-Daten entsprechend, dass es in den folgenden Auswertealgorithmen nutzbar ist.

In der Datenbank kann dabei eine Vielzahl von Datensätze in Bezug auf (jeweils) ein (herzustellendes und/oder zu inspizierendes) Behältnis abgelegt sein. In der in Fig. 2 dargestellten Datenbank sind beispielsweise die Datensätze 101, 102, 103, 104 und 105 zu verschiedenen (Kunden-)Behältnissen abgelegt. Ein zu einem Behältnis zugehöriger Datensatz kann mittels einer Referenz-Kennung 100 und/oder einer Bezeichnung insbesondere eindeutig identifizierbar sein.

Weiterhin kann ein einem (herzustellenden und/oder zu inspizierenden) Behältnis zugeordneter Datensatz eine Kundenbezeichnung des Behältnisses und/oder ein Kundenkennzeichen wie eine Kundennummer umfassen.

Bevorzugt umfasst ein einem (herzustellenden und/oder zu inspizierenden) Behältnis zugeordneter Datensatz neben den Daten eines Modells des Behältnisses Eigenschaften und/oder Merkmale des (herzustellenden und/oder zu identifizierenden) Behältnisses, welche ausgewählt sein können aus einer Gruppe, die ein (Nenn-)Volumen, ein (Nenn-)Gewicht, einen Werkstoff, eine (Gesamt-)Höhe, einen (Außen-) und/oder (Innen-)Durchmesser und dergleichen sowie Kombinationen hiervon umfasst.

Ein einem (herzustellenden und/oder zu inspizierenden) Behältnis zugeordneter Datensatz kann neben den Daten eines Modells des Behältnisses auch Daten umfassen, die charakteristisch sind für ein Füllgut, eine Ausstattung des Behältnisses wie ein Etikett, ein Verschluss, ein Mundstück, eine Palette, ein Preform, ein Gebinde, ein Packgut, ein Packhilfsmittel, eine, Füllgut-Zuordnung, eine Ausstattungszuordnung, wie beispielsweise eine Etiketten-Zuordnung, und/oder eine Preform-Zuordnung.

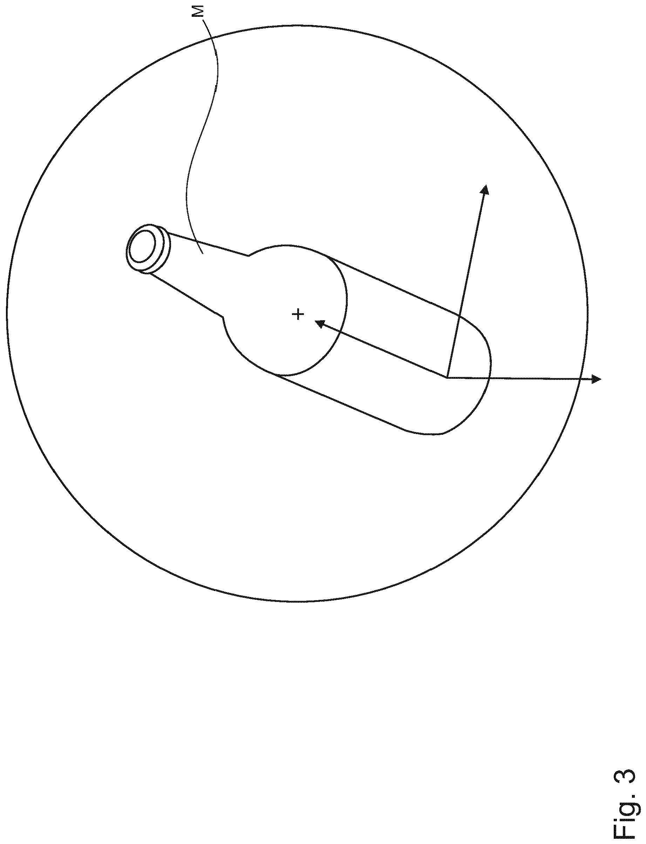

Fig. 3 zeigt eine Darstellung eines Modells M eines Behältnisses zusammen mit einer Ausrichtung des Modells, welche durch ein Koordinatensystem dargestellt wird. Hierdurch kann die Auswertung eines aufgenommenen Bildes genau an die Ausrichtung des zu inspizierenden Behältnisses angepasst werden. Hierfür können beispielsweise Daten des Modells derart verarbeitet werden, etwa durch eine Rotation, dass die Ausrichtung des Modells an die Ausrichtung des zu inspizierenden Behältnisses bzw. an die Ausrichtung des Behältnisses auf dem aufgenommenen Bilde angepasst wird. Hierdurch ist ein unmittelbarer Vergleich des Modells mit dem aufgenommenen Bild möglich, ohne dass die Bilddaten gedreht oder dergleichen werden müssen.

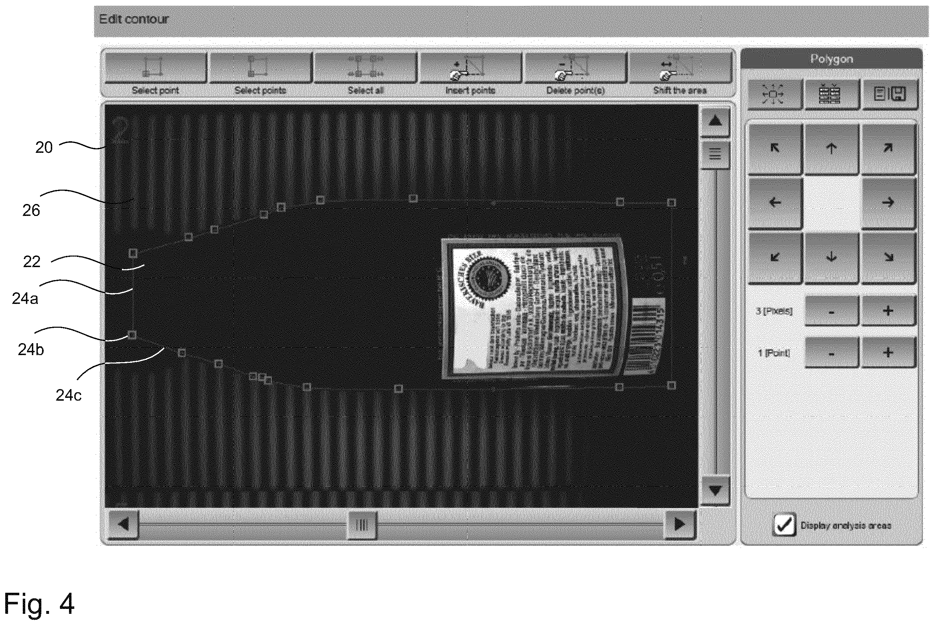

Fig. 4 zeigt ein von einer Inspektionseinrichtung 4, insbesondere von einer Bildaufnahmeeinrichtung 42 wie einer Kamera, aufgenommenes Bild 20 zur Veranschaulichung der Auswertung dieses Bildes 20.

Ein derartiges aufgenommenes Bild 20 wird üblicherweise zur Auswertung parametriert, etwa indem eine Konturlinie 24a, 24b und 24c durch Vergleich des Behältnisses 22 im Vordergrund des Bildes mit einem (hier gestreiften) abgebildeten Hintergrund 26 des aufgenommenen Bildes 20 erzeugt wird.

Durch Bestimmung der (relativen) Lage der Knotenpunkte 24b und/oder der Ausdehnung und/oder relativen (Winkel-)Beziehungen und/oder Längen einzelner Abschnitte der Konturenlinie 24a, 24c zueinander und Vergleich mit der Kontur, die etwa aus den Daten eines Modells des Behältnisses erzeugt wird, kann dabei beispielsweise auf eine bestimmte Behältnissorte geschlossen werden.

Die Anmelderin behält sich vor, sämtliche in den Anmeldungsunterlagen offenbarten Merkmale als erfindungswesentlich zu beanspruchen, sofern sie einzeln oder in Kombination gegenüber dem Stand der Technik neu sind. Es wird weiterhin darauf hingewiesen, dass in den einzelnen Figuren auch Merkmale beschrieben wurden, welche für sich genommen vorteilhaft sein können. Der Fachmann erkennt unmittelbar, dass ein bestimmtes in einer Figur beschriebenes Merkmal auch ohne die Übernahme weiterer Merkmale aus dieser Figur vorteilhaft sein kann. Ferner erkennt der Fachmann, dass sich auch Vorteile durch eine Kombination mehrerer in einzelnen oder in unterschiedlichen Figuren gezeigter Merkmale ergeben können.

### Bezugszeichenliste

- 1: Vorrichtung
- 2: Transporteinrichtung
- 4: Inspektionseinrichtung
- 10: Behältnis
- 20: aufgenommenes Bild
- 22: abgebildetes, zu inspizierendes Behältnis
- 24a - c: Behältniskontur
- 26: abgebildeter Hintergrund
- 42: Bildaufnahmeeinrichtung
- 44: Bildauswerteeinrichtung
- 50: Beleuchtungseinrichtung
- 100: Referenzkennung
- 101 - 105: Datensätze
- M: Modell

## Patentansprüche

1. Verfahren zum Inspizieren von Behältnissen (10), wobei die Behältnisse (10) mittels einer Transporteinrichtung (2) entlang eines vorgegebenen Transportpfads transportiert werden und mittels einer Inspektionseinrichtung (4) inspiziert werden, wobei die Inspektionseinrichtung (4) mittels einer Bildaufnahmeeinrichtung (42) wenigstens ein ortsaufgelöstes Bild eines zu inspizierenden Behältnisses (10) aufnimmt und eine Bildauswerteeinrichtung (44) dieses Bild auswertet,
**dadurch gekennzeichnet, dass**
zur Auswertung dieses Bildes Daten eines Modells (M) dieses Behältnisses (10) verwendet werden.

2. Verfahren nach Anspruch 1,
**dadurch gekennzeichnet, dass**
es sich bei den Daten des Modells (M) um dreidimensionale Daten handelt, welche für das Modell dieses Behältnisses (10) charakteristisch sind.

3. Verfahren nach wenigstens einem der vorangegangenen Ansprüche,
**dadurch gekennzeichnet, dass**
auf Basis der Daten ein Referenzmodell des Behältnisses erstellt wird, welches zur Auswertung des aufgenommenen Bildes verwendet wird.

4. Verfahren nach wenigstens einem der vorangegangenen Ansprüche,
**dadurch gekennzeichnet, dass**
auf Basis der Daten des Modells (M) automatisch wenigstens eine zur Auswertung des aufgenommenen Bildes zu verwendende Auswertungsgröße ermittelt wird.

5. Verfahren nach wenigstens einem der vorangegangenen Ansprüche,
**dadurch gekennzeichnet, dass**
eine synthetische Aufnahme eines 3D- Modells des Behältnisses an einer vorgegebenen wählbaren Position im Raum erstellt wird.

6. Verfahren nach wenigstens einem der vorangegangenen Ansprüche,
**dadurch gekennzeichnet, dass**
zur Auswertung des aufgenommenen Bildes eine gegenüber räumlichen Operationen, insbesondere gegenüber Skalierungen, Rotationen und/oder Translationen, invariante Größe des Modells des Behältnisses (10) verwendet wird.

7. Verfahren nach wenigstens einem der vorangegangenen Ansprüche,
**dadurch gekennzeichnet, dass**
die Inspektionseinrichtung (4) wenigstens einen Wert ausgibt, der für das inspizierte Behältnis charakteristisch ist.

8. Verfahren nach wenigstens einem der vorangegangenen Ansprüche,
**dadurch gekennzeichnet, dass**
durch die Bildauswertung eine Behältnissortierung und/oder eine Behältniskontrolle durchgeführt wird, welche aus einer Gruppe von Behältniskontrollen ausgewählt ist, welche eine Fremdbehältniserkennung, eine Ausstattungskontrolle, eine Etikettenkontrolle, eine Mündungskontrolle, eine Seitenwandinspektion, eine Seitenwanderkennung von Kunststoffvorformlingen und dergleichen enthält.

9. Verfahren nach wenigstens einem der vorangegangenen Ansprüche,
**dadurch gekennzeichnet, dass**
aus den Daten Dimensionen für eine 360° - Abwicklung des Behältnisses gewonnen werden, wobei bevorzugt diese Dimensionen aus einer Gruppe von Dimensionen ausgewählt sind, welche eine Höhe des Behältnisses, einen Durchmesser des Behältnisses, einen Mündungsquerschnitt des Behältnisses, eine seitliche Kontur des Behältnisses eine seitliche Kontur eines Mündungsbereiches des Behältnisses eine seitliche Kontur eines Halses des Behältnisses und dergleichen enthält.

10. Verfahren nach wenigstens einem der vorangegangenen Ansprüche,
**dadurch gekennzeichnet, dass**
eine Kalibrierung des auf Basis der Daten ermittelten Modells gegenüber dem aufgenommenen Bild ermittelt wird.

11. Verfahren nach wenigstens einem der vorangegangenen Ansprüche,
**dadurch gekennzeichnet, dass**
die Daten aus einer Speichereinrichtung in die Auswerteeinrichtung geladen werden.

12. Verfahren nach wenigstens einem der vorangegangenen Ansprüche,
**dadurch gekennzeichnet, dass**
Objektpunkte des 3D - Modells zurück in die Bildaufnahmeeinrichtung (42) projiziert werden und bevorzugt einem Objektpunkt ein charakteristischer Wert und insbesondere ein Farbwert zugeordnet wird.

13. Verfahren nach wenigstens einem der vorangegangenen Ansprüche,
**dadurch gekennzeichnet, dass**
eine Kontur des Behältnisses aus einem 3D- Modell des Behältnisses erzeugt wird.

14. Vorrichtung (1) zum Inspizieren von Behältnissen (10) mit einer Transporteinrichtung (2), welche die Behältnisse (10) entlang eines vorgegebenen Transportpfads transportiert und mit einer Inspektionseinrichtung (4), welche die Behältnisse inspiziert, wobei die Inspektionseinrichtung (4) eine Bildaufnahmeeinrichtung (42) aufweist, welche wenigstens ein ortsaufgelöstes Bild eines zu inspizierenden Behältnisses (10) aufnimmt und eine Bildauswerteeinrichtung (44) vorgesehen ist, welche dieses Bild auswertet,
**dadurch gekennzeichnet, dass**
die Bildauswerteeinrichtung (44) zur Auswertung dieses Bildes Daten eines Modells (M) dieses Behältnisses (10) verwendet.

15. Vorrichtung (1) nach dem vorangegangenen Anspruch,
**dadurch gekennzeichnet, dass**
die Vorrichtung (1) eine Modellerstellungseinrichtung aufweist, welche unter Verwendung der Daten ein dreidimensionales Modell eines Referenzbehältnisses erstellt.
